# EUROPÄISCHE PATENTSCHRIFT

(11) **EP 0 470 963 B1**
(45) Veröffentlichungstag und Bekanntmachung des Hinweises auf die Patenterteilung: **05.01.1994**
(21) Anmeldenummer: 90905506.3
(22) Anmeldetag: 14.04.1990
(51) Int. Cl.: H03J 5/02

(54) **RUNDFUNKEMPFÄNGER MIT DIGITALER FREQUENZEINGABE**
RADIO RECEIVER WITH DIGITAL FREQUENCY SELECTION
RECEPTEUR RADIO AVEC ENTREE NUMERIQUE DE FREQUENCE

(30) Priorität: 22.04.1989 DE 3913278
(43) Veröffentlichungstag der Anmeldung: 19.02.1992
(73) Patentinhaber: DEUTSCHE THOMSON-BRANDT GMBH, 78048 Villingen-Schwenningen (DE)
(72) Erfinder: FÜLDNER, Friedrich, D-7730 Villingen (DE)
(86) Internationale Anmeldenummer: EP9000590
(87) Internationale Veröffentlichungsnummer: WO9013176

(56) Entgegenhaltungen:
- DE-A- 3 119 122
- US-A- 4 122 395

## Beschreibung

Die Erfindung geht aus von einem Rundfunkempfänger gemäß dem Oberbegriff des Anspruchs 1. Ein derartiger Rundfunkempfänger ist z.B. aus dem Dokument US-A-4 122 395 bekannt.

Die Eingabe der meist dreistelligen Frequenz für den gewünschten Sender erfolgt in der Regel mit einer Tastatur mit Tasten von 1 - 0. Im Regelfall müssen somit drei Tasten betätigt werden. Dabei kommt es leicht zu Fehlbedienungen. Wenn eine Frequenz eingegeben wird, bei der kein Sender liegt, wird dieses in einem Display dem Benutzer mitgeteilt, damit er eine erneute Eingabe machen kann.

Der Erfindung liegt die Aufgabe zugrunde, bei einem Rundfunkempfänger der beschriebenen Art die manuelle Frequenzeingabe für den jeweils gewünschten Sender zu vereinfachen und die Häufigkeit von Fehleingaben zu verringern. Diese Aufgabe wird durch die im Anspruch 1 angegebenen Erfindung gelöst. Vorteilhafte Weiterbildungen der Erfindung sind in den Unteransprüchen angegeben.

Die Erfindung beruht auf folgender Erkenntnis. Wenn z.B. im Mittelwellenbereich alle Senderfrequenzen ein ganzzahliges vielfaches von 9 kHz sind, also alle Sender in gleichen Frequenzabständen von 9 kHz liegen, ist jeweils die Quersumme der Frequenz = 9. Wenn somit bei einer dreistelligen Frequenz die beiden ersten Ziffern eingegeben sind, so kann in den meisten Fällen aufgrund des bekannten Frequenzabstandes die dritte, letzte Ziffer von einem Prozessor selbsttätig errechnet werden. Die Eingabe der letzten Ziffer ist daher in der Vielzahl aller Eingabefälle nicht erforderlich. Dann vielmehr kann die letzte Ziffer vom Prozessor selbsttätig ermittelt und für die Anzeige und die Abstimmung verwertet werden, können auch Fehleingaben in der letzten Ziffer nicht mehr erfolgen. In den Fällen, in denen die letzte Ziffer nach Eingabe der beiden ersten Ziffern zweideutig ist, wird vorzugsweise im Display die Stelle für die letzte Ziffer zum Blinken angeregt als Hinweis für den Bedienenden, in diesem Fall die letzte Ziffer einzugeben. Diese Notwendigkeit besteht jedoch nur in etwa 20% aller Eingabefälle. In 80% aller Eingabefälle ist nach der Eingabe bis zur vorletzten Ziffer die letzte Ziffer eindeutig. Die Bedienung wird auch in sofern vereinfacht, als der Bedienende in den meisten Fällen die Frequenz nicht genau bis zur letzten Ziffer wissen muß.

Die Erfindung wird anhand der Zeichnung an einem Ausführungsbeispiel erläutert. Darin zeigen
- Fig. 1: das Blockschaltbild eines erfindungsgemäß ausgebildeten Rundfunkempfängers,
- Fig. 2: die Frequenzlage der Sender und
- Fig. 3, 4: die Anzeige von eingegebenen Frequenzen im Mittelwellenbereich.

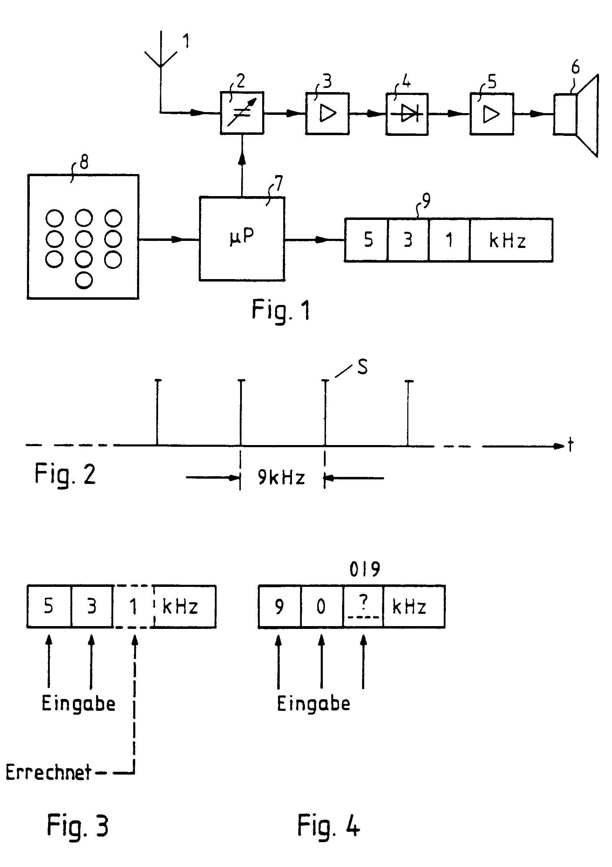

Fig. 1 zeigt einen Mittelwellen-Rundfunkempfänger mit der Antenne 1, dem abstimmbaren HF-Teil 2, dem ZF-Verstärker 3, dem Demodulator 4, dem NF-Verstärker 5 und dem Lautsprecher 6. Das abstimmbare HF-Teil 2 wird von dem Mikroprozessor 7 gesteuert, an den die Tastatur 8 und das Display 9 angeschlossen sind. Die Frequenz eines gewünschten Senders wird manuell in die Zehnertastatur 8 eingegeben und dem Prozessor 7 zugeführt, der daraufhin die Abstimmung in dem HF-Teil 2 auf den gewünschten Sender und die Anzeige der eingegebenen Frequenz auf dem Display 9 auslöst.

Gemäß Fig. 2 liegen im Mittelwellenbereich alle Sender S in einem äquidistanten Frequenzabstand von 9 kHz. Die Quersumme der Ziffer einer Frequenz ist daher stets gleich 9. Jede Senderfrequenz ist also ein ganzzahliges Vielfaches von 9 kHz.

In Fig. 3 ist angenommen, daß die Frequenz des gewünschten Senders 531 kHz beträgt. Für die Abstimmung auf diesen Sender wird zunächst die erste Ziffer 5 manuell in die Tastatur 8 eingegeben. Im Anschluß daran wird manuell die zweite Ziffer 3 eingegeben. In diesem Augenblick errechnet der Prozessor 7 die letzte Ziffer, die jetzt eindeutig ist und wegen der bekannten Frequenzlage nur die Ziffer 1 sein kann. Die beiden benachbarten Sender haben dann nämlich die Frequenzen 522 und 540 kHz. Daher folgt in einem kaum wahrnehmbaren kurzen Zeitpunkt nach der Eingabe der Ziffer 3 bereits auf dem Display 9 eine Angabe der vollständigen Frequenz 531 kHz, obwohl die letzte Ziffer 1 manuell nicht eingegeben wurde. Gleichzeitig erfolgt die Abstimmung des Empfängers auf diese Frequenz.

Fig. 4 zeigt ein Beispiel dafür, daß die letzte Ziffer nach Eingabe der beiden ersten Ziffern nicht eindeutig ist. Nach Eingabe der beiden ersten Ziffern 9 und 0 kommen hier zwei Frequenzen in Frage, nämlich 900 kHz und 909 kHz. Der Prozessor 7 bewirkt daher auf dem Display 9 ein Blinken der Stelle für die letzte Ziffer als Aufforderung an den Bedienenden, in diesem Falle auch die letzte Ziffer manuell einzugeben.

Für den Prozessor 7 in Fig. 1 kann ein Mikroprozessor vom Typ µ PD75308 der Fa. NEC verwendet werden.

## Patentansprüche

1. Rundfunkempfänger mit digitaler Frequenzeingabe für den gewünschten Sender für in gleichen Frequenzabständen (9 kHz) liegende Sender, **dadurch gekennzeichnet,** daß ein Prozessor (7) vorgesehen ist, der nach Eingabe der Frequenz bis zur vorletzten Ziffer ("3") selbsttätig die letzte Ziffer ("1") aufgrund des bekannten Frequenzabstandes (9 kHz) errechnet und die Abstimmung des Empfängers sowie die Anzeige der Frequenz auslöst.

2. Empfänger nach Anspruch 1, **dadurch gekennzeichnet,** daß in den Fällen, in denen die letzte Ziffer ("0" oder "9") zweideutig ist, im Display (9) ein Hinweis an den Bedienenden erfolgt, auch die letzte Ziffer manuell einzugeben.

## Claims

1. Radio broadcast receiver, using digital frequency entry for the wanted transmitter, for transmitters having the same frequency separation (9 kHz), characterised in that, there is provided a processor (7) which, after the frequency has been entered up to the penultimate digit ("3"), automatically calculates the last digit ("1") on the basis of the known frequency separation (9 kHz) and initiates the tuning of the receiver as well as the display of the frequency.

2. Receiver in accordance with Claim 1, characterised in that, in the cases in which the last digit ("0" or "9") is ambiguous, an indication to the user to also manually enter the last digit occurs in the display (9).

## Revendications

1. Récepteur de radiodiffusion avec entrée numérique de la fréquence pour l'émetteur souhaité pour des émetteurs qui se situent à des intervalles de fréquences égaux (9 kHz), **caractérisé en ce** qu'il est prévu un processeur (7) qui, après l'entrée de la fréquence jusqu'à l'avant-dernier chiffre ("3"), calcule automatiquement le dernier chiffre ("1") en raison de l'écart connu entre les fréquences (9 kHz) et déclenche l'accord du récepteur ainsi que l'affichage de la fréquence.

2. Récepteur selon la revendication 1, **caractérisé en ce** que dans les cas où le dernier chiffre ("0" ou "9") est équivoque il apparaît une indication dans le panneau d'affichage (9) pour l'utilisateur pour qu'il introduise également le dernier chiffre manuellement.
